# EUROPEAN PATENT APPLICATION

(11) **EP 1 542 239 A1**
(43) Date of publication of application: **15.06.2005**
(21) Application number: 04029243.5
(22) Date of filing: 09.12.2004
(51) Int. Cl.: H01B 1/22

(54) **Metal paste and film formation method using the same**

(30) Priority: 12.12.2003 JP 2003415487
(71) Applicant: Tanaka Kikinzoku Kogyo K.K., Tokyo 103-8206 (JP)
(72) Inventor: Nakagawa, Hirofumi, Hiratsuka-shi Kanagawa 254-0076 (JP); Takaoka, Kenichiro, Atsugi-shi Kanagawa 243-0213 (JP)
(74) Representative: Klunker . Schmitt-Nilson . Hirsch

(57) **Abstract**

A metal paste comprising a mixture consisting of: metal colloidal particles, which consist of particles consisting of one or more metals or metal oxides and a protective agent for protecting the particles; and organic metallic compounds. The metal paste preferably comprising a mixture consisting of: metal colloidal particles comprising, as a protective agent, a compound having an amino group, sulfanyl group, sulfide-type sulfanediyl group, hydroxy group, or ether-type oxy group; and organic metallic compounds such as mercaptan metallic compounds or sulfide metallic compounds of α-pinene, α-terpinenol, or isobornyl acetate, abietic acid metallic compounds, neodecanoic acid metallic compounds, 2-ethylhexanoic acid metallic compounds, naphthenic acid metallic compounds, or decanoic acid metallic compounds.

## Description

### BACKGROUND OF THE INVENTION

### Field of the Invention

The present invention relates to a metal paste that can be applied to the formation of a wiring pattern of electronic equipment or the like, and a film formation method using the metal paste.

### Description of the Related Art

A plating method has generally been applied to form a wiring pattern of a circuit board of electronic equipment, an electrode film, etc. In some cases, however, such a plating method is not necessarily preferable in terms of problems regarding the treatment of waste liquid. Thus, instead of the plating method, a method using a metal paste has recently become a focus of attention as a promising method. A metal paste used for this method is formed by mixing an organic resin, solvent, or the like into an inorganic or organic metallic compound such as gold, as appropriate. In order to form a film, such a metal paste is applied onto a substrate by means such as screen printing and then sintered, so as to eliminate the solvent and sinter the metal, thereby forming a film.

Conventionally, a metal paste comprising submicron-order fine metal powders (inorganic metals) has generally been used. However, a metal paste comprising metal powders has a problem regarding the generation of voids in a film after a burning treatment performed after application of the paste. This is ascribable to a fact that the particle size of a metal powder is too large. During film formation, since a particle layer is small while voids among particles are great, it results in a lack of compactness.

Thus, various types of metal pastes have been developed to solve the problems regarding a metal paste into which metal powders are mixed. For example, Japanese Patent Application Laid-Open No. 5-144318 discloses a metal paste comprising organic metallic compounds instead of metal powders. This metal paste is formed by using gold organic compounds such as mercaptan metallic compounds or sulfide metallic compounds of α-pinene, α-terpinenol, or isobornyl acetate, and mixing a solvent or the like into the gold organic compounds.

For another example, Japanese Patent Application Laid-Open No. 2003-103158 discloses a metal paste into which metal colloidal particles are mixed. The term "colloid" is used herein to mean a state in which nano-order fine particles (hereinafter referred to as particles) are dispersed and suspended in a solvent. The term "metal colloid" is used to mean agglutinated metal particles. Patent Document 2 discloses that a solvent in which metal colloidal particles are dispersed is applied onto a substrate and then sintered, so as to produce a metal film with electric conductivity.

The two above described metal pastes contribute to improve problems of metal pastes comprising metal powders. However, these metal pastes have different problems from those of the metal pastes comprising metal powders. This is to say, the thickness of a film formed by a single application and a single sintering of a metal paste comprising organic metallic compounds is smaller than a film formed from a metal paste comprising metal powders. This is because the thickness of a sintered film formed as a result of a single application of a metal paste mainly depends on the concentration of metals in the metal paste. In the case of an organic metallic compound-containing paste, the content of metals cannot be more than 30% by weight. Accordingly, in order to obtain a film having a desired film thickness, multiple times of application are required. In other words, multiple steps are required, resulting in poor efficiency in the production of metal films.

On the other hand, a metal paste comprising metal colloidal particles overcomes problems regarding voids or the film thickness. However, the present inventors have pointed out a problem that the compactness of a film after sintering is poorer than the case where organic metallic compounds are applied. The compactness of a film is associated with the resistance value of the film (electric conductivity). A film with poor compactness has a high resistance value, and thus, it may affect the performance of electronic equipment. In contrast, a film with a low resistance value cannot respond to a finer pattern formation in the future.

The present invention has been made against the above described background. It is an object of the present invention to provide a metal paste capable of achieving a sufficient film thickness by a single application of the paste, thereby producing a compact film with no voids.

### SUMMARY OF THE INVENTION

The present inventors have focused attention on the advantages of metal colloidal particles, and at the same time, they have tried to overcome the disadvantages thereof. As a result, the present inventors have thought that although metal colloidal particles are nano-order fine particles, it does not mean that no voids are generated among the metal colloidal particles during application, but that voids are generated although they are very fine. The present inventors have also thought that such voids cause poor compactness of a film in the film formation in which metal colloidal particles are used. Thus, the present inventors have studied means for preventing the generation of voids among particles during the application of a paste comprising metal colloidal particles. As a result, they have found that the above problems are solved by mixing metal colloidal particles with organic metallic compounds.

The present invention relates to a metal paste comprising a mixture consisting of: metal colloidal particles, which consist of particles consisting of one or more metals or metal oxides and a protective agent for protecting the particles; and organic metallic compounds.

The present invention allows both metal colloidal particles and organic metallic compounds to exhibit their advantages. Namely, since metal colloidal particles are extremely small particles, a film consisting of a large number of layers is formed when the above metal paste is applied, and thus, voids are hardly generated. Further, since metal colloidal particles are made from metal with high purity, when a paste containing such particles is applied, large quantities of metal particles can be applied on a substrate, so that a thick film can be formed by a single application. Furthermore, voids that are slightly generated among particles are filled with organic metallic compounds, so that the compactness of a film can be ensured after sintering. Thus, according to the present invention, a compact film with no defects can be efficiently produced in a few steps.

The reason why a protective agent for protecting particles is used as an essential element for metal colloidal particles in the present invention is that such a protective agent is essential for suppressing agglutination of particles in a paste and maintaining the particle size thereof. The term "protective agent" is used herein to mean a compound, which chemically or physically binds and adsorbed around particles to suppress agglutination of particles and to adjust the particle size distribution thereof in an adequate range for stabilization.

Such a protective agent is a compound, which comprises at least any one of nitrogen, oxygen, and sulfur, so as to prevent a decrease in the purity of a film, and which has a group capable of coordinating to a metal or metal oxide constituting the particles. Specifically, it is preferable that the protective agent be a compound comprising an amino group, sulfanyl group, sulfide-type sulfanediyl group, hydroxy group, or ether-type oxy group. More specifically, alkylamine is preferable as a compound comprising an amino group. In this case, a primary amine compound shows a particularly high binding ability, but a secondary amine compound or tertiary amine compound can also be applied. In addition, an amino compound in which two or more amino groups adjacent to one another are associated with binding, such as a 1,2-diamine compound or 1,3-diamine compound, can also be applied. Alkanethiol is an example of a compound comprising a sulfanyl group. In this case, a primary thiol compound shows a particularly high binding ability, but a secondary thiol compound or tertiary thiol compound can also be applied. In addition, a thiol compound in which two or more amino groups adjacent to one another are associated with binding, such as a 1,2-dithiol compound or 1,3-dithiol compound, can also be applied. Alkanediol is an example of a compound comprising a hydroxy group, and those comprising two or more hydroxyl groups, such as a 1,2-diol compound, can be applied.

Moreover, organic metallic compounds constituting the present invention with metal colloidal particles are not particularly limited. A compound formed by binding at least any one of nitrogen, sulfur, or oxygen to a metal ion can be applied. More specifically, organic metallic compounds are preferably of one or more selected from the group consisting of: mercaptan metallic compounds or sulfide metallic compounds of α-pinene, α-terpinenol, or isobornyl acetate; abietic acid metallic compounds; neodecanoic acid metallic compounds; 2-ethylhexanoic acid metallic compounds; naphthenic acid metallic compounds; and decanoic acid metallic compounds. Since these compounds are good in stability of complexes, no impurities are remained after sintering. Further, these compounds are inexpensive.

In the present invention, it is preferable that the content of metals (the amount of metals derived from metal colloidal particles and organic metallic compounds) in a metal paste be between 10% and 90% by weight. The content of metals is particularly preferably between 30% and 50% by weight. If the content of metals is less than 30% by weight, the efficiency in film formation would be poor in some cases. In contrast, if it exceeds 50% by weight, an organic solvent or organic resin can be deficient and thereby it can become difficult to perform screen printing in some cases. In addition, metal colloidal particles are preferably mixed with organic metallic compounds such that the ratio of the metal colloidal particles is between 10% and 70% by weight based on the total weight of metals contained in the paste. If the ratio of metal colloidal particles is too high, the viscosity of the paste becomes too low, and thereby it becomes difficult to form a film by screen printing. In contrast, if the ratio of metal colloidal particles is decreased and the ratio of organic metallic compounds is increased, it is impossible to keep the content of metals in the paste high.

Furthermore, in the present invention, a certain resin or solvent is preferably added to a mixture consisting of metal colloidal particles and organic metallic compounds. This is because a certain level of viscosity is ensured, so as to have good handlability during the application of the paste. Examples of such a resin or solvent to be applied may include: organic resins such as gum rosin, alkyd resin, gum Kovar, or gum dammar; organic solvents such as terpinenol, isobornyl acetate, or alkene; and additives such as bismuth octoate or lead octoate. The additive amount of these additives may preferably be approximately between 0.5% and 8% by weight based on the total amount of metals in the paste.

Metals used as particles constituting the metal colloidal particles of the present invention, and metals constituting the organic metallic compounds of the present invention, are not particularly limited. Taking into consideration the use as a metal paste, gold, platinum, silver, palladium, rhodium, iridium, ruthenium, osmium, tungsten, nickel, tantalum, bismuth, lead, zinc, tin, titanium, and aluminum are preferable. Either only one or several metals may be used herein. In addition, in order to ensure the compactness of a film, particles constituting the metal colloidal particles preferably have a particle size between 0.5 nm and 100 nm.

Next, a method for producing the metal paste of the present invention will be described. The metal paste of the present invention comprises a mixture consisting of metal colloidal particles and organic metallic compounds. Accordingly, the production method of the metal paste of the present invention mainly comprises steps of producing the metal colloidal particles, producing the organic metallic compounds, mixing both components, and also mixing a solvent or the like into the mixture.

With regard to the production method of the metal colloidal particles, it is preferable that a metal colloidal solution be first produced, and that the solution be then concentrated and filtrated to extract metal colloidal particles, which is then subj ected to the production of a paste. In order to produce a metal colloidal solution, it is preferable that a reduction method, which has conventionally been known as a production method of metal colloids, be basically applied. The reduction method involves dissolving metal salts from metals constituting particles in a solvent, so as to ionize them, and adding a protective agent and a reducing agent thereto, so as to reduce metal ions into particles and also to protect the generated particles with the protective agent. The protective agent may also be dissolved in a solvent at the same time when metal salts are dissolved. In order to disperse particles consisting of several metals, several metal salts may be dissolved in a solvent.

When platinum colloids are produced, examples of metal salts used as raw materials may include hexachloroplatinic acid, dinitro diamine platinum, dinitro diamine platinum nitrate, platinum I chloride, platinum II chloride, platinic chloride, and platinate chloride. When palladium colloids are produced, examples of metal salts used as raw materials may include palladium chloride, palladium nitrate, and dinitro diamine palladium. When gold colloids are produced, examples of metal salts used as raw materials may include chloroauric acid, gold II potassium cyanide chloroaurate, and gold potassium cyanide. When silver colloids are produced, examples of metal salts used as raw materials may include silver chlorate, silver nitrate, silver acetate, and silver lactate. When ruthenium colloids are produced, examples of metal salts used as raw materials may include ruthenium chloride and ruthenium nitrate. When rhodium colloids are produced, examples of metal salts used as raw materials may include rhodium chloride, rhodium nitrate, and rhodium acetate. When iridium colloids are produced, examples of metal salts used as raw materials may include hexachloroiridium acid and iridium trichloride. When osmium colloids are produced, osmium oxide or the like may be used as a metal salt. With regard to other metals also, nitrate or acetate can be applied.

A reducing agent used herein is not particularly limited, as long as it can be applied to a chemical reduction method. A reducing agent capable of reducing a mixed solution consisting of metal salts and a protective agent may be used. Preferred examples of such a reducing agent may include alcohol such as ethanol, formic acid, hydrogen, hydrazine, amines, sodium borohydride, and dimethylamine borane.

Addition of a reducing agent allows metal ions to be reduced into metal particles. At the same time, by the action of the reducing agent, particles are stabilized in the state of fine particles, so that they become a metal colloid solution. Thereafter, by filtrating the metal colloid solution, it becomes possible to extract metal colloidal particles.

Organic metallic compounds can be produced by known production methods, which depend on organic compounds. Commercially available compounds may also be used.

Organic resins or solvents may be added as appropriate to the metal colloids and organic metallic compounds produced by the above described steps, and these are then blended, so as to produce the metal paste of the present invention. As a method for forming a film using the metal paste of the present invention, the spin coater method, the screen printing method, or the ink-jet method can be applied.

Further, the metal paste of the present invention may further comprise metal powders. When metal powders are further added, the content of metals in the paste can be further increased, so that the thickness of a film obtained by a single application of the paste can be increased.

As stated above, using the metal paste of the present invention, a compact metal film with no defects such as voids or cracks can be produced. A metal film produced from the metal paste of the present invention has a low resistance value and also has good properties as a conductor film. Such effects can be obtained because the metal paste of the present invention comprises metal colloidal particles consisting of extremely fine particles and also because it further comprises organic metallic compounds capable of filling in voids that are generated among colloidal particles during the application of the paste.

In addition, according to the metal paste of the present invention, a thick film can be formed by a single application, so that the efficiency in the production of a conductor film can be improved. This is because the content of metals in the paste can be increased by the use of metal colloids. In the case of a conventional paste only comprising organic metallic compounds, the content of metals cannot be increased, and thus, the thickness of a metal film formed by a single application was 0.5 µm or less. In the case of the metal paste of the present invention, however, a metal film with a thickness of approximately 1 µm can be formed by a single application. The metal paste of the present invention is preferably used in the formation of a conductor film such as an electrode. However, by applying metal oxide particles, a resistance film or insulator film can also be formed from the paste.

### BRIEF DESCRIPTION OF THE DRAWINGS

FIG. 1 is a photograph showing an appearance of a metal film (gold) produced in the present embodiment;
FIG. 2 is a photograph showing an appearance of a metal film (gold) produced in Comparative Example 1;
FIG. 3 is a photograph showing an appearance of a metal film (gold) produced in Comparative Example 2; and
FIG. 4 is a photograph showing the appearance of a metal film (gold) produced in Comparative Example 3.

### DETAILED DESCRIPTION OF THE PREFERRED EMBODIMENTS

A preferred embodiment of the present invention will be described below. In the present embodiment, using n-decanethiol-protected gold colloids as metal colloidal particles, and using sulfide gold compounds of α-pinene as organic metallic compounds, a gold paste was produced.

### Production of gold colloids:

8.34 g of chloroauric acid (gold content: 4.0 g) was dissolved in 800 ml of water. A solution obtained by dissolving 26.248 g of tetraoctylammonium bromide in 1600 ml of toluene was added to the above solution, and the obtained mixture was stirred. After completion of the stirring, 4.184 g of n-decanethiol as a protective agent was added thereto, and further, 1L of a sodium borohydride aqueous solution (5%) as a reducing agent was added dropwise thereto over 60 minutes. Thereafter, the mixture was stirred at room temperature for 12 hours, so that it was fully reacted. Then, toluene was eliminated using a rotary evaporator. Thereafter, 250 ml of toluene and 1500 ml of ethanol were added thereto, and the obtained mixture was left at rest for 2 hours in a refrigerator. Thereafter, the resultant product was filtrated, so as to obtain 4.65 g of black n-decanethiol-protected gold colloids (gold content: 76.1 % by weight).

### Production of organic gold compounds:

A mixture consisting of 100 g of α-pinene and 25 g of sulfur monochloride (S₂Cl₂) was heated at 100°C for 1 hour. Thereafter, 20 g of chloroauric acid dissolved in 200 ml of ethanol was added thereto, and the mixture was stirred at 80°C for 1 hour. The obtained product was cooled to room temperature, and then, 600 ml of ethanol was added thereto. The mixture was left to remove a supernatant. Thereafter, the deposit was fully dried, so as to obtain 24.5 g of sulfide gold compounds of α-pinene (gold content: 67.95% by weight).

### Production of gold paste:

A gold paste was produced with the use of the above produced n-decanethiol-protected gold colloids and sulfide gold compounds of α-pinene. In the production of the gold paste, an organic resin, a solvent, and an additive were added at the following mixing ratio.
Gold colloids: 17% by weight of gold
Organic gold compound: 20% by weight of gold
Alkyd resin (organic resin): 18% by weight
α-terpinenol (solvent): 44.7% by weight
Bismuth octoate: 0.3% by weight

### Comparative Example 1:

As a Comparative Example to the present embodiment, a gold paste was produced with the use of gold powders. Gold powders having a particle size of 0.3 µm were used herein. An organic resin, a solvent, and an additive were added to the gold powders in the following mixing ratio.
Gold powders: 41 % by weight
Ethyl cellulose (organic resin): 50% by weight
Isobornyl acetate (solvent): 8.2% by weight
Glass frit: 0.8% by weight

### Comparative Example 2:

In this Comparative Example, a gold paste was produced with the use of only the gold colloids (n-decanethiol-protected gold colloids) produced in the present embodiment. The mixing ratio of components is as follows.
Gold colloids: 34% by weight of gold
Rosin resin/gum dammar (organic resin): 36% by weight
α-terpinenol (solvent): 29.4% by weight
Bismuth octoate: 0.6% by weight

### Comparative Example 3:

Further, a gold paste was produced with the use of only the organic metallic compounds (sulfide gold compounds of α-pinene) produced in the present embodiment. The mixing ratio of components is as follows.
Organic metallic compounds: 20% by weight of gold
Rosin resin/gum dammar (organic resin): 35% by weight
α-terpinenol (solvent): 35.1% by weight
Bismuth octoate and lead octoate: 0.5% by weight

### Production of gold film:

Gold films were produced with the use of the gold pastes produced in the present embodiment and Comparative Examples 1 and 2, and the properties thereof were analyzed. Each film was formed by the screen printing of each gold paste on a soda lime substrate, using a #400 mesh screen, and after the printing, by sintering it at a peak temperature of 600°C for a peak sintering time of 6 minutes in a muffle conveyor furnace.

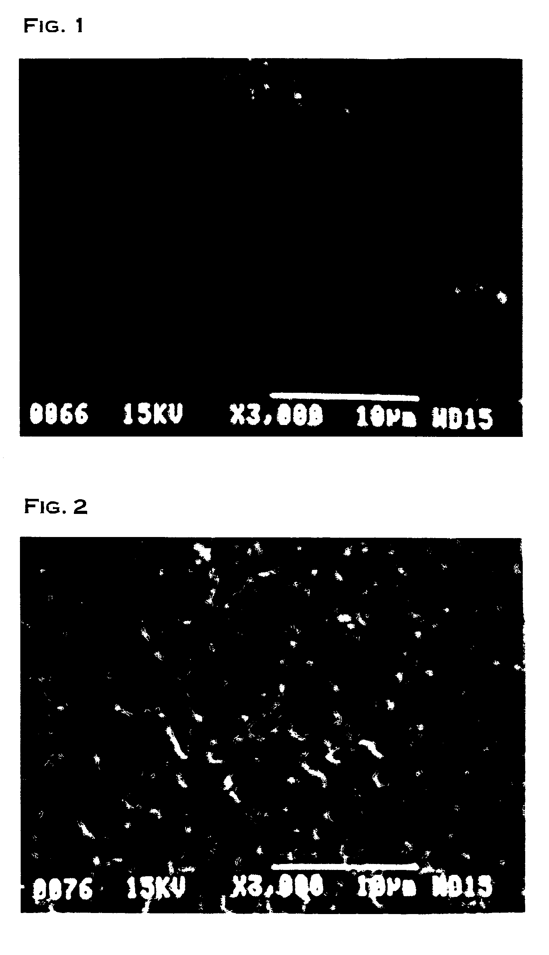

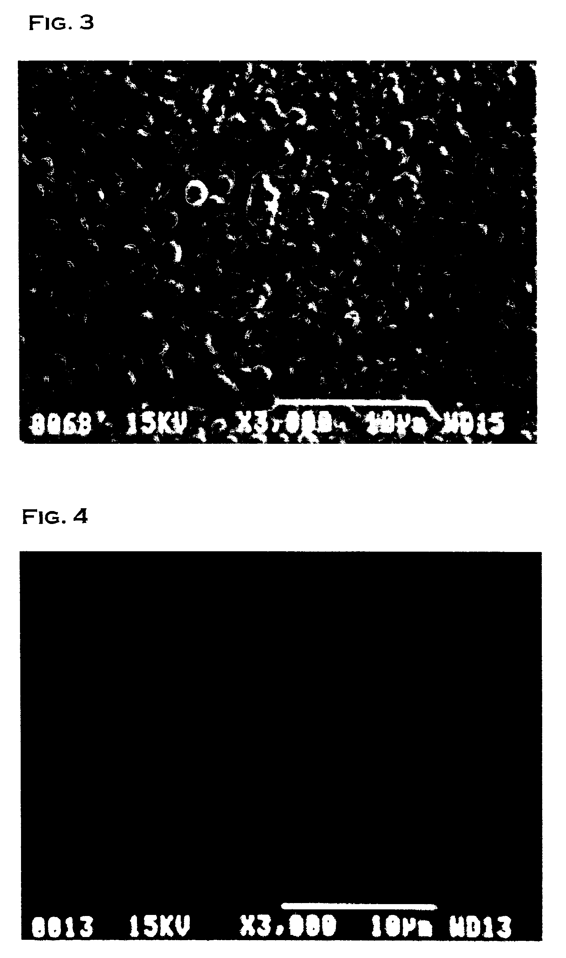

FIGS. 1 to 3 are photographs showing the appearances of the obtained films. In addition, the film thickness of each film and the sheet resistance value thereof are shown in Table 1.

**Table 1**

| | Film thickness (µm) | Sheet resistance* (mΩ/sq. at 1 µm) |
|---|---|---|
| The present embodiment | 1.2 | 38.0 |
| Comparative Example 1 | 1.1 | 126.0 |
| Comparative Example 2 | 0.84 | 76.0 |
| Comparative Example 3 | 0.3 | 42.0 |

| | | |
|---|---|---|
| *: a resistance value in terms of a film thickness of 1 µm | | |

As is clear from FIG. 1, a film produced with the use of the paste in the present embodiment has a good compactness even after sintering, and has no defects such as voids or cracks. In contrast, in the case of the gold powder paste in Comparative Example 1, voids are observed in the formed film. In addition, in the case of the gold colloid paste in Comparative Example 2, clear defects are not observed, but it causes poor sintering properties and the poor compactness of the formed film.

Moreover, from Table 1, it is found that the paste in the present embodiment provides a good film thickness of the formed film. In contrast, the thickness of a film formed from the paste in Comparative Example 3 is considerably smaller than that of a film formed from the paste in the present embodiment. This is ascribable to a fact that only the use of organic metallic compounds cannot increase the content of metals in the paste. The resistance value of the metal film obtained in the present embodiment is one-half or less of those of the films produced from other pastes, and thus, it was confirmed that the film obtained in the present embodiment has extremely good properties as a conductor film. Accordingly, it is the metal paste in the present embodiment that satisfies all the requirements including the form of a film, an electric conductivity, and film formation efficiency.

## Claims

1. A metal paste comprising a mixture consisting of: metal colloidal particles, which consist of particles consisting of one or more metals or metal oxides and a protective agent for protecting the particles; and organic metallic compounds.

2. The metal paste according to claim 1, wherein the protective agent is a compound, which comprises at least any one of nitrogen, oxygen, and sulfur, and has a group capable of coordinating to a metal or metal oxide constituting the particles.

3. The metal paste according to claim 1 or 2, wherein the protective agent is a compound comprising an amino group, sulfanyl group, sulfide-type sulfanediyl group, hydroxy group, or ether-type oxy group.

4. The metal paste according to any one of claims 1 to 3, wherein the organic metallic compound is formed by binding at least any one of nitrogen, sulfur, and oxygen, with a metal ion.

5. The metal paste according to any one of claims 1 to 4, wherein the organic metallic compounds are of one or more selected from the group consisting of: mercaptan metallic compounds or sulfide metallic compounds of α-pinene, α-terpinenol, or isobornyl acetate; abietic acid metallic compounds; neodecanoic acid metallic compounds; 2-ethylhexanoic acid metallic compounds; naphthenic acid metallic compounds; and decanoic acid metallic compounds.

6. The metal paste according to any one of claims 1 to 5, wherein the content of metals is between 10% and 90% by weight.

7. The metal paste according to any one of claims 1 to 6, wherein the metal colloidal particles are mixed with the organic metallic compound, such that the ratio of the metal colloidal particles is between 10% and 70% by weight based on the total weight of metals contained in the paste.

8. The metal paste according to any one of claims 1 to 7, wherein metals constituting the particles and the organic metallic compound are one or more metals or metal oxides selected from the group consisting of gold, platinum, silver, palladium, rhodium, iridium, ruthenium, osmium, tungsten, nickel, tantalum, bismuth, lead, zinc, tin, titanium, and aluminum.

9. The metal paste according to any one of claims 1 to 8, wherein the particles have a particle size between 0.5 nm and 100 nm.

10. The metal paste according to any one of claims 1 to 9, which further comprises metal powders.

11. A method for forming a film by the spin coater method, the screen printing method, or the ink-jet method, with the use of the metal paste according to any one of claims 1 to 10.
